# EUROPÄISCHE PATENTSCHRIFT

(11) **EP 1 010 014 B1**
(45) Veröffentlichungstag und Bekanntmachung des Hinweises auf die Patenterteilung: **01.10.2003**
(21) Anmeldenummer: 98933519.5
(22) Anmeldetag: 13.05.1998
(51) Int. Cl.: G01R 15/00

(54) **MAGNETKERN**
MAGNET CORE
NOYAU MAGNETIQUE

(30) Priorität: 13.05.1997 DE 19720010
(43) Veröffentlichungstag der Anmeldung: 21.06.2000
(73) Patentinhaber: Vacuumschmelze GmbH, 63450 Hanau (DE)
(72) Erfinder: LENHARD, Friedrich, D-63452 Hanau (DE)
(74) Vertreter: Patentanwälte Westphal, Mussgnug & Partner
(86) Internationale Anmeldenummer: DE9801327
(87) Internationale Veröffentlichungsnummer: WO98052052

(56) Entgegenhaltungen:
- EP-A- 0 367 942
- WO-A-97/45849
- DE-A- 4 035 043
- US-A- 4 953 286
- US-A- 5 515 597
- PATENT ABSTRACTS OF JAPAN vol. 010, no. 343 (E-456), 19. November 1986 & JP 61 147518 A (TAKAOKA IND LTD), 5. Juli 1986

## Beschreibung

Die Erfindung betrifft einen Magnetkern für Stromsensoren aus einer weichmagnetischen Legierung, sowie einen Stromsensor enthaltend diesen Magnetkern.

Magnetkerne für Kompensationsstromsensoren aus weichmagnetischen Legierungen sind seit längerer Zeit bekannt. Charakteristisch für diese Kerne ist es, daß im Inneren des Sekundärschenkels des Kerns oder in einem Luftspalt ein Magnetfeldsensor, beispielsweise ein Hall-Element, angeordnet ist. Im allgemeinen ist der den Sensor umfassende Sekundärschenkel in eine Kompensationsspule eingeschoben. In bekannten Ausführungsformen von Kompensationsstromsensoren werden die Magnetkerne entweder als geschlitzte Ringkerne oder als wechselseitig gestapelte Bleche ausgeführt.
Das Aufbringen einer Wicklung für die Kompensationsspule auf den Sekundärschenkel ist im Falle von Ringkernen aus geschlitzten Blechen sehr aufwendig.

Die Magnetkerne vom zweiten Typ aus wechselseitig gestapelten Blechen lassen sich zwar ohne aufwendiges Wickeln durch Stecken des Kerns in eine vorgefertigte Spule herstellen, allerdings erfordert diese Vorgehensweise das Stanzen der Kernbleche aus einem Band oder Blech. Während des Stanzens bleibt in der Regel ein hoher Prozentsatz des Kernmaterials als Abfall übrig. Dieser Verlust muß entweder durch einen höheren Materialaufwand ausgeglichen werden oder es ist notwendig, das verlorene Material durch einen Rezyklisierungsschritt dem Ausgangsmaterial wieder zuzuführen. Entsprechende Maßnahmen sind jedoch aufgrund ökonomischer Überlegungen nur eingeschränkt sinnvoll.

Die wechselseitig gestapelten Kernbleche vom zweiten Typ werden bekanntlich auch aus rechteckig geformten Blechen, welche zur Aufnahme des Magnetfeldsensors einen Schlitz im Bereich des Sekundärschenkels aufweisen, hergestellt. Die im vorstehenden Absatz aufgeführten Nachteile aufgrund der Herstellung durch Stanzen gelten auch für die hier genannte Kernbleche.

Aus Patent Abstracts of Japan, Vol. 010, No. 343 (E-456), 19. November 1986, JP-A 61 147 518 ist ein Magnetkern bekannt, welcher in der Weise gewickelt ist, daß zwischen zusammentreffenden Schenkelabschnitten der spiegelsymmetrisch zueinander geformten Magnethälften ein Luftspalt gebildet wird. Die DE-A 40 35 043 einen aus zwei Teilen zusammengefügten Magnetkern, der jedoch aus massivem Ferrit gefertigt ist.

Aufgabe der vorliegenden Erfindung ist es nun, einen Magnetkern der letztgenannten Art zu schaffen, der ökonomisch hergestellt werden kann und die Nachteile der bekannten Magnetkerne für Stromsensoren nicht aufweist.

Diese Aufgabe wird erfindungsgemäß gelöst durch einen Magnetkern für Stromsensoren aus einer weichmagnetischen Legierung bestehen aus mindestens. zwei gebogenen oder geknickten Legierungsbandabschnitten welcher gekennzeichnet ist durch die Merkmale des Anspruchs 1.

Vorzugsweise besteht der erfindungsgemäße Magnetkern aus zwei gebogenen Legierungsbandabschnitten.

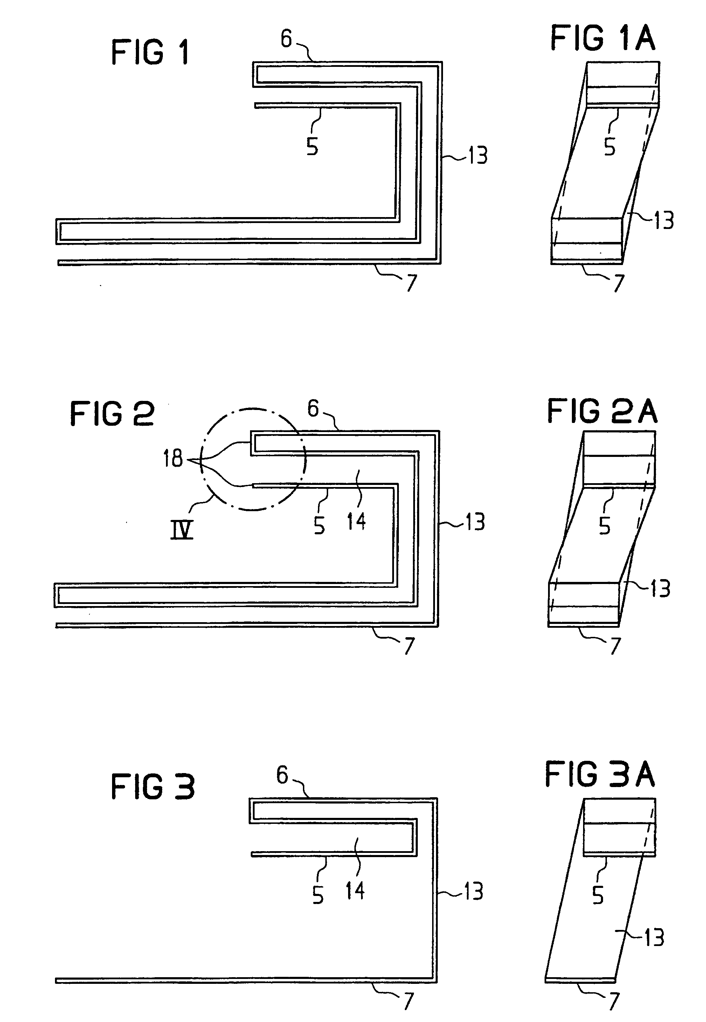

Das Legierungsband ist vorzugsweise so gebogen oder geknickt, daß die gebogenen oder geknickten Legierungsbandabschnitte einen Winkel von 90° oder 180° zueinander aufweisen. Beispiele für entsprechend gebogene Kerne zeigen die Figuren 1, 2, 3, 5, 6, 7 und 10.

Werden die erfindungsgemäßen Kerne für Kompensationsstromsensoren eingesetzt, so weisen diese im nicht erfindungsgemäße allgemeinen einen Primär- und einen Sekundärschenkel auf, welcher im Bereich des Sekundärschenkels bevorzugt aus mindestens zwei Bandabschnitten 5 und 6 gebildet ist.

Die Bandabschnitte 5 und 6 können So geformt sein, daß diese im Bereich des Sekundärschenkels einen Zwischenraum, eine Tasche bzw. einen Hohlraum 14 bilden. Dieser Zwischenraum dient beispielsweise zur Aufnahme eines Magnetfeldsensors.

Beispiele für entsprechende Ausführungsformen sind in den Fig. 2, 3, 7 und 10 dargestellt. Es ist ebenfalls möglich, die Abschnitte 5 und 6 so zu formen, daß kein entsprechender Zwischenraum, wie beispielsweise in den Fig. 1, 5 und 6 dargestellt, vorhanden ist.

Der Kern weist vorzugsweise einen Primärschenkelabschnitt 7 auf, dessen Längsachse 15 zu den Flächen der Sekundärschenkelabschnitte 5,6 parallel orientiert ist.

Der Primärschenkel kann in einer weiteren bevorzugten Ausführungsform so angeordnet sein, daß die Längsachse 15 parallel zur Längsachse 16 des Sekundärschenkels orientiert ist.

Im letztgenannten Fall ist der Primärschenkelabschnitt 8 dann zu den Flächen des Sekundärschenkels in einer Weiterbildung verdreht zum seitlichen Flächenabschnitt 13 orientiert. Vorzugsweise ist dann die Verdrehung so ausgeführt, daß die Fläche des Sekundärschenkelabschnitts 8 senkrecht zum seitlichen Kernabschnitt 13 orientiert ist.

Bei dem erfindungsgemäßen Magnetkern kann es sich um ein aus einem einzigen Bandstück hergestellten Kern handeln, oder auch vorzugsweise um einen aus mindestens zwei oder mehr Teilen zusammengesetzten Kern.

Besonders bevorzugt ist der Magnetkern jedoch aus einem ersten Teil 1 und einem zweiten Teil 2 zusammengesetzt, wobei die Teile 1,2 spiegelsymmetrisch zueinander geformt sind.

Die Legierungsbandabschnitte, die den Magnetkern bilden, sind zweckmäßigerweise so angeordnet, daß daß an der Sekundärseite die nach innen gerichteten Kanten 18 des oder der Sekundärschenkelabschnitte 5,6 des ersten Teils 1 und die nach innen gerichteten Kanten des oder der Sekundärschenkelteile 9,10 des zweiten Teils 2 zumindest teilweise aneinander stoßen.
Unter den zusammentreffenden Schenkelabschnitten befindet sich vorzugsweise mindestens ein Schenkelpaar 10,12 oder 5,9, welches einen Luftspalt 17 bildet. Wenn der Sekundärschenkel aus zwei Schenkelpaaren besteht bedeutet dies, daß die Sekundärschenkelteile des ersten Paars aneinander stoßen und die Sekundärschenkel des anderen Paars nicht, so daß diese einen Luftspalt bilden.
D.h., daβ an der Sekundärseite die Schenkelabschnitte 5,6 und die Schenkelteile 9,10 zumindest teilweise Kante-an-Kante aneinander liegen.

Die Sekundärschenkel können auch aus mehreren Bandabschnitten 5,6 bestehen, die parallel in einem bestimmten Abstand voneinander verlaufen und in der Regel beide in eine Magnetspule hineinragen.

Vorzugsweise ist das erste und das zweite Teil 1,2 so angeordnet und geformt, daß sich an der Primärseite der primärseitige Schenkelabschnitt des ersten Teils 7 und der primärseitige Schenkelabschnitt des zweiten Teils 11 zumindest teilweise flächig überlappen.

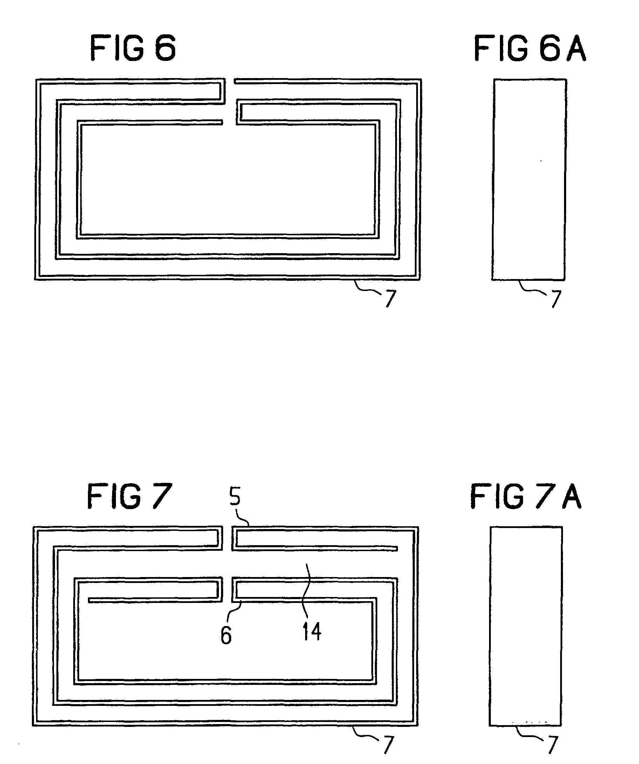

In einer weiteren bevorzugten Ausführungsform ist das erste und das zweite Teil 1,2 konisch geformt, sodaß an der Primärseite der primärseitige Schenkelabschnitt des ersten Teils 7 und der primärseitige Schenkelabschnitt des zweiten Teils 11 eine aus zwei Dreiecken 19 gebildete gemeinsame rechteckige Fläche 20 bilden. Ein Beispiel für eine entsprechende Anordnung zeigen die Figuren 5,5a und 5b (Aufsicht, Längsansicht, Seitenansicht)

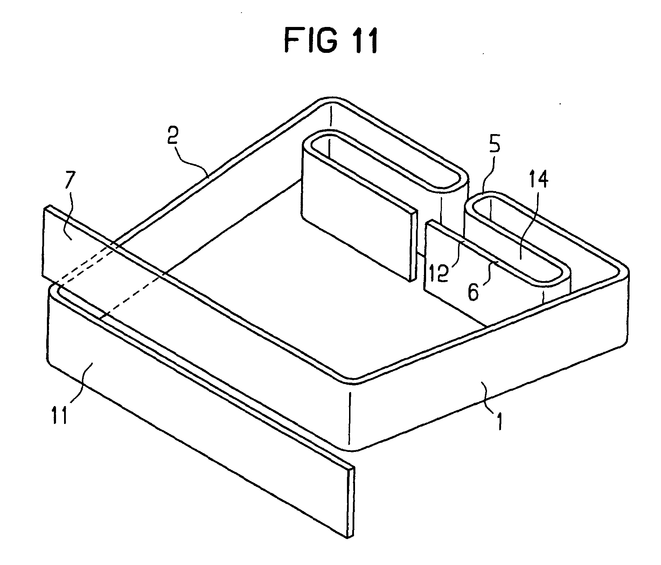

Als weitere bevorzugte Ausführungsform ist das erste und das zweite Magnetkernteil 1,2 so geformt, daß die Seitenflächen 13 schräg verlaufen, sodaß an der Primärseite der primärseitige Schenkelabschnitt des ersten Teils 7 und der primärseitige Schenkelabschnitt des zweiten Teils 11 parallel zueinander verlaufen, wobei die Flächen der primärseitigen Schenkelabschnitte 7,11 auf einer Ebene zu liegen kommen. Ein Beispiel für eine solche Anordnung ist in Fig. 11 in räumlicher Darstellung gezeichnet.

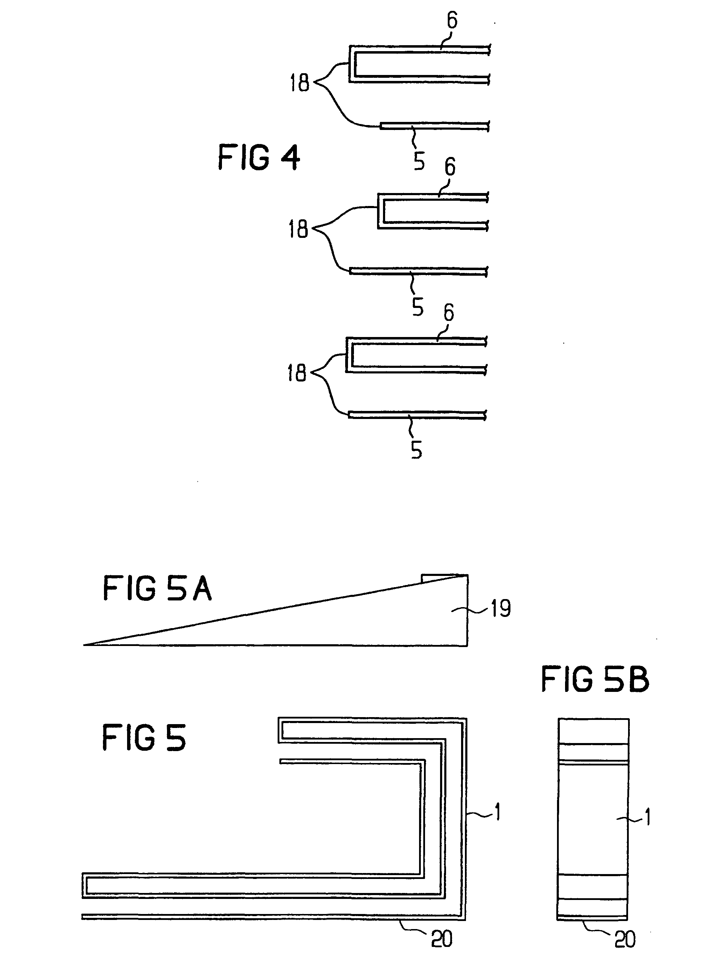

Ein weiterer Gegenstand der Erfindung ist ein Magnetkern mit einem Primärschenkel und einem Sekundärschenkel, welcher dadurch gekennzeichnet ist, daß der Sekundärschenkel aus einem Legierungsbandabschnitt in Einzellage 5 und einem Legierungsbandabschnitt in Doppellage 6 gebildet ist. Beispiele für in dieser Weise geformte Sekundärschenkel zeigt die Figur 4. Die Figur 4 stellt eine Ausschnittsvergrößerung des kreisförmigen Bereichs in Fig. 2 dar. Die dargestellten Sekundärschenkelformen lassen sich analog auch bei Ausführungsformen in den Figuren 1, 2, 3 und 5 anwenden.

Vorzugsweise bilden der Legierungsbandabschnitt in Einzellage und der Legierungsbandabschnitt in Doppellage eine Tasche oder einen Hohlraum 14 mit einem Volumen von mindestens 1 mm³, vorzugsweise 4 mm³, welcher zur Aufnahme eines Magnetfeldsensors geeinget ist.

Die Erfindung betrifft ferner einen Stromsensor mit den Merkmalen des Anspruchs 12, der sich dadurch auszeichnet, daß er einen Magnetkern gemäß der Erfindung enthält.

Die Erfindung betrifft auch ein Verfahren mit den Merkmalen des Anspruchs 13; dieses dient zur Herstellung des zusammengesetzten Magnetkerns gemäß der Erfindung umfassend die Schritte:
a) Herstellung eines Legierungsbandes aus einem weichmagnetischen Material,
   - Biegen oder Knicken des Legierungsbandes in der Weise, daß mindestens zwei Legierungsbandabschnitte (5,6,7,8,11,12,13) entstehen, die einen Winkel von 90° oder 180° zueinander aufweisen,
   - Abtrennen oder Schneiden des Bandes auf die gewünschte Länge, wobei das Abtrennen oder Schneiden vor oder nach dem Biegen oder Knicken des Bandes erfolgen kann und vorzugsweise
b) Zusammensetzen von mindestens zwei gemäß Schritt a) hergestellten Bändern (1,2) zu einem Magnetkern.

Es ist ein besonderer Vorteil der vorliegenden Erfindung, daß durch Ersetzen der herkömmlichen Kernbleche durch erfindungsgemäß geformte Bandabschnitte das Stanzen entfallen kann. Hierduch läßt sich der beim Stanzen prinzipbedingt entstehende Abfall auf einfache Weise vermeiden. Vorteilhafterweise kann das eingesetzte weichmagnetische Material ohne Materialverlust voll ausgenutzt werden.

Je nach Anwendung, für die der erfindungsgemäße Kern eingesetzt werden soll, kann der Fachmann gemäß dem Verfahren der Erfindung den Querschnitt des Kerns auf besonders einfache Weise an die von der Anwendung vorgegebenen Anforderungen einstellen. Der gewünschte Querschnitt läßt sich durch geeignetes mehrfaches Knicken oder Biegen des Bandes erreichen.

Die Erfindung wird im folgenden anhand der Figuren 1 bis 11 näher erläutert:
- Figur 1: zeigt eine Kernhälfte für einen Stromsensor mit Hall-Sensor (nicht gezeichnet). Bei dieser Ausführungsform befindet sich der Hall-Sensor in einem Luftspalt zwischen zwei symmetrischen Kernhälften.
- Figur 2: zeigt eine Kernhälfte für einen Stromsensor mit Tasche bzw. Hohlraum 14 zur Aufnahme eines Magnetfeldsensors mit metallischem Magnetfelddetektor oder magnetoresistiven Sensor.
- Figur 3: zeigt eine Kernhälfte für einen Stromsensor mit metallischem Magnetfelddetektor oder magnetoresistiven Sensor mit partiell vermindertem Querschnitt entsprechend der Seitenansicht in Fig. 5a,
- Figur 5: zeigt eine weitere Ausführungsform für eine Kernhälfte,
- Figur 5a: zeigt einen abgeschrägten Sekundärschenkel zur Platzoptimierung, wie er bei den Ausführungsformen entsprechend der Figuren 1 bis 4 angewendet werden kann,
- Figur 6: zeigt einen Ersatz für einen gestapelten Kern für einen Stromsensor mit Hall-Generator in ungeteilter Bauweise,
- Figur 7: zeigt einen Ersatz für einen gestapelten Kern für einen Stromsensor mit metallischem Magnetfelddetektor oder magnetoresistiven Sensor in ungeteilter Bauweise,
- Figuren 1a bis 3a, 5b, 6a und 7a: stellen die Kerne der Figuren 1 bis 3, 5 bis 7 in Längsansicht dar,

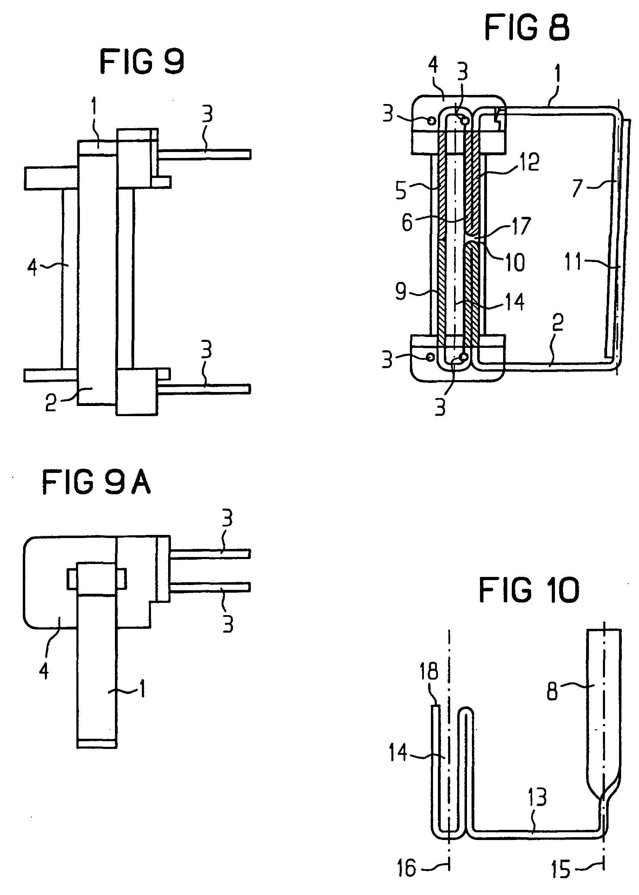

- Figur 8: zeigt einen Magnetkern 1,2 für einen Kompensationsstromsensor mit einem Spulengehäuse 4 am Sekundärschenkel des Magnetkerns,
- Figur 9: zeigt den Kompensationsstromsensor aus Figur 7 in Seitenansicht,
- Figur 9a: zeigt den Kompensationsstromsensor aus Figur 7 in Längsansicht,
- Figur 10: zeigt einen Legierungsbandabschnitt für einen Magnetkern mit um 90° gegenüber dem Seitenabschnitt 13 verdrehten Primärschenkel 8 und
- Figur 11: zeigt ein weiteres Ausführungsbeispiel eines Magnetkerns.

Der in Fig. 8 dargestellte Magnetkern ist aus einem ersten Kernteil 1 und einem zweiten Kernteil 2 derart zusammengesetzt, daß die Sekundärschenkelabschnitte 5,6 des ersten Legierungsbandabschnittes mit dem Sekundärschenkel des zweiten Legierungsbandabschnittes Kante-an-Kante aneinander liegen. Die an der Innenseite befindlichen Teile des Sekundärschenkels sind verkürzt ausgeführt, so daß sich an der Verbindungsstelle ein Luftspalt 17 bildet. Überraschenderweise läßt sich die Empfindlichkeit eines Kompensationsstromsensors oder eines ähnlichen Beuteils verbessern, wenn mindestens ein Luftspalt 17 im Bereich des Sekundärschenkels vorhanden ist. In Fig. 8 ist der Primärschenkelabschnitt 7 derart angeordnet, daß sich der Primärschenkel des ersten Legierungsbandabschnittes 7 und der Primärschenkel des zweiten Legierungsbandabschnittes 11 flächig überlappen. Eine flächige Überlappung am Primärschenkel liegt auch bei der in Fig. 10 dargestellten Ausführungsform für eine Kernhälfte vor. Bei dieser Ausführungsform überlappen die Abschnitte 8 der beiden Kernhälften.

Ein Stromsensor enthaltend den erfindungsgemäßen Kern ist in den Figuren 8, 9 und 9a gezeichnet. Der zusammengesetzte Kern aus den Teilen 1 und 2 wird von einer Kompensationsspule 4 umfaßt. Die Kontaktdurchführungen 3 für die Kompensationsspule 4 und den nicht gezeichneten Magnetfeldsensor sind am Gehäuseboden herausgeführt. Der Magnetfeldsensor ist in einer Tasche 14 angeordnet.

## Patentansprüche

1. Magnetkern für Stromsensoren aus einer weichmagnetischen Legierung bestehend aus mindestens zwei gebogenen oder geknickten Legierungsbandabschnitten (5, 6, 7, 8, 11, 12, 13), **dadurch gekennzeichnet,**
**daß** der Magnetkern aus einem ersten Teil eines Magnetkerns (1) und einem zweiten Teil eines Magnetkerns (2) zusammengesetzt ist, wobei die Magnetkernteile (1, 2) spiegelsymmetrisch zueinander geformt sind und daß das erste und das zweite Magnetkernteil (1, 2) so angeordnet ist, daß an der Sekundärseite die nach innen gerichteten Kanten (18) des oder der Sekundärschenkelabschnitte (5, 6) des ersten Magnetkernteils (1) und die nach innen gerichteten Kanten des oder der Sekundärschenkelteile (9, 10) des zweiten Magnetkernteils (2) zumindest teilweise aneinander stoßen, wobei unter den zusammentreffenden Schenkelabschnitten mindestens ein Schenkelpaar (10, 12; 5, 9) einen Luftspalt (17) bildet.

2. Magnetkern nach Anspruch 1, **dadurch gekennzeichnet, daß** der Magnetkern aus zwei gebogenen Legierungsbandabschnitten besteht.

3. Magnetkern nach Anspruch 1 oder 2, **dadurch gekennzeichnet, daß** das Legierungsband so gebogen oder geknickt ist, daß die gebogenen oder geknickten Legierungsbandabschnitte (5,6,7,8,11,12,13) einen Winkel von 90° oder 180° zueinander aufweisen.

4. Magnetkern nach mindestens einem der Ansprüche 1 bis 3, **dadurch gekennzeichnet, daß** der Sekundärschenkel aus mindestens zwei Legierungsbandabschnitten (5) und (6) gebildet ist, sodaß innerhalb des Magnetkerns im Bereich des Sekundärschenkels eine Tasche oder ein Hohlraum (14) entsteht, welcher zur Aufnahme eines Magnetfeldsensors geeignet ist.

5. Magnetkern nach mindestens einem der Ansprüche 1 bis 4, **dadurch gekennzeichnet, daß** der Magnetkern im Bereich des Primärschenkels einen Legierungsbandabschnitt (7) aufweist, welcher zu den Flächen des Sekundärschenkels (5,6) parallel orientiert ist.

6. Magnetkern nach mindestens einem der Ansprüche 1 bis 4, **dadurch gekennzeichnet, daß** der Magnetkern einen Primärschenkel aufweist, dessen Längsachse (15) parallel zur Längsachse (16) des Sekundärschenkels orientiert ist.

7. Magnetkern nach mindestens einem der Ansprüche 1 bis 5, **dadurch gekennzeichnet, daß** der Magnetkern aus einem ersten Teil eins Magnetkerns (1) und einem zweiten Teil eines Magnetkerns (2) zusammengesetzt ist, wobei die Magnetkernteile (1,2) spiegelsymmetrisch zueinander geformt sind.

8. Magnetkern nach Anspruch 7, **dadurch gekennzeichnet, daß** das erste und das zweite Magnetkernteil (1,2) so angeordnet ist, daß an der Sekundärseite die nach Innen gerichteten Kanten (18) des oder der Sekundärschenkelabschnitte (5,6) des ersten Magnetkernteils (1) und die nach Innen gerichteten Kanten des oder der Sekundärschenkelteile (9,10) des zweiten Magnetkernteils (2) zumindest teilweise aneinander stoßen, wobei unter den zusammentreffenden Schenkelabschnitten mindestens ein Schenkelpaar (10,12 oder 5,9) einen Luftspalt (17) bildet.

9. Magnetkern nach mindestens einem der Ansprüche 1 bis 8, **dadurch gekennzeichnet, daß** das erste Magnetkernteil (1) und das zweite Magnetkernteil (2) so angeordnet und geformt ist, daß sich an der Primärseite der Schenkelabschnitt des ersten Magnetkernteils (7) und der primärseitige Schenkelabschnitt des zweiten Magnetkernteils (11) zumindest teilweise flächig überlappt.

10. Magnetkern nach mindestens einem der Ansprüche 1 bis 8, **dadurch gekennzeichnet, daß** das erste und das zweite Magnetkernteil (1,2) konisch geformt ist, sodaß an der Primärseite der konische Schenkelabschnitt des ersten Magnetkernteils (7,19) und der konische Schenkelabschnitt des zweiten Magnetkernteils (11) eine aus zwei Dreiecken (19) gebildete gemeinsame rechteckige Fläche (20) bilden.

11. Magnetkern nach mindestens einem der Ansprüche 1 bis 8, **dadurch gekennzeichnet, daß** das erste und das zweite Magnetkernteil (1,2) so geformt ist, daß die Seitenflächen (13) schräg verlaufen, sodaß an der Primärseite der Schenkelabschnitt des ersten Teils (7) und der Schenkelabschnitt des zweiten Teils (11) parallel zueinander verlaufen, wobei die Flächen der primärseitigen Schenkelabschnitte (7,11) auf einer Ebene zu liegen kommen.

12. Stromsensor, **dadurch gekennzeichnet, daß** er einen Magnetkern nach Anspruch 1 enthält.

13. Verfahren zur Herstellung eines Magnetkerns nach Anspruch 1 umfassend die Schritte:
- Herstellung eines Legierungsbandes aus einem weichmagnetischen Material,
- Biegen oder Knicken des Legierungsbandes in der Weise, daß mindestens zwei Legierungsbandabschnitte (5,6,7,8,11,12,13) entstehen, die einen Winkel von 90° oder 180° zueinander aufweisen und
- Abtrennen oder Schneiden des Bandes auf die gewünschte Länge, wobei das Abtrennen oder Schneiden vor oder nach dem Biegen oder Knicken des Bandes erfolgen kann.

14. Verfahren nach Anspruch 13, **dadurch gekennzeichnet, daß** der Magnetkern aus mindestens zwei Bändern (1,2) zusammengesetzt wird.

## Claims

1. Magnetic core for current sensors made of a soft-magnetic alloy, comprising at least two bent or buckled alloy strip portions (5, 6, 7, 8, 11, 12, 13), **characterized in that** the magnetic core is composed of a first part of a magnetic core (1) and a second part of a magnetic core (2), the magnetic core parts (1, 2) being formed mirror-symmetrically in relation to one another, and **in that** the first and the second magnetic core parts (1, 2) are arranged in such a way that on the secondary side the inwardly directed edges (18) of the secondary leg portion or portions (5, 6) of the first magnetic core part (1) and the inwardly directed edges of the secondary leg part or parts (9, 10) of the second magnetic core part (2) at least partially butt against one another, at least one pair of legs (10, 12; 5, 9) among the abutting leg portions forming an air gap (17).

2. Magnetic core according to Claim 1, **characterized in that** the magnetic core comprises two bent alloy strip portions.

3. Magnetic core according to Claim 1 or 2, **characterized in that** the alloy strip is bent or buckled in such a way that the bent or buckled alloy strip portions (5, 6, 7, 8, 11, 12, 13) are at an angle of 90° or 180° in relation to one another.

4. Magnetic core according to at least one of Claims 1 to 3, **characterized in that** the secondary leg is formed by at least two alloy strip portions (5) and (6), so that a pocket or a cavity (14) which is suitable for receiving a magnetic field sensor is produced within the magnetic core in the region of the secondary leg.

5. Magnetic core according to at least one of Claims 1 to 4, **characterized in that** the magnetic core has in the region of the primary leg an alloy strip portion (7) which is oriented parallel to the faces of the secondary leg (5, 6).

6. Magnetic core according to at least one of Claims 1 to 4, **characterized in that** the magnetic core has a primary leg, the longitudinal axis (15) of which is oriented parallel to the longitudinal axis (16) of the secondary leg.

7. Magnetic core according to at least one of Claims 1 to 5, **characterized in that** the magnetic core is composed of a first part of a magnetic core (1) and a second part of a magnetic core (2), the magnetic core parts (1, 2) being formed mirror-symmetrically in relation to one another.

8. Magnetic core according to Claim 7,**characterized in that** the first and the second magnetic core parts (1, 2) are arranged in such a way that on the secondary side the inwardly directed edges (18) of the secondary leg portion or portions (5, 6) of the first magnetic core part (1) and the inwardly directed edges of the secondary leg part or parts (9, 10) of the second magnetic core part (2) at least partially butt against one another, at least one pair of legs (10, 12 or 5, 9) among the abutting leg portions forming an air gap (17).

9. Magnetic core according to at least one of Claims 1 to 8, **characterized in that** the first magnetic core part (1) and the second magnetic core part (2) are arranged and formed in such a way that on the primary side the leg portion of the first magnetic core part (7) and the primary-side leg portion of the second magnetic core part (11) overlap at least partly over their surface areas.

10. Magnetic core according to at least one of Claims 1 to 8, **characterized in that** the first and the second magnetic core parts (1, 2) are conically formed, so that on the primary side the conical leg portion of the first magnetic core part (7, 19) and the conical leg portion of the second magnetic core part (11) form a common rectangular face (20) formed by two triangles (19).

11. Magnetic core according to at least one of Claims 1 to 8, **characterized in that** the first and the second magnetic core parts (1, 2) are formed in such a way that the side faces (13) run obliquely, so that on the primary side the leg portion of the first part (7) and the leg portion of the second part (11) run parallel to one another, the faces of the primary-side leg portions (7, 11) coming to lie on one plane.

12. Current sensor, **characterized in that** it contains a magnetic core according to Claim 1.

13. Method for producing a magnetic core according to Claim 1, comprising the steps of:
- producing an alloy strip from a soft-magnetic material,
- bending or buckling the alloy strip in such a way as to produce at least two alloy strip portions (5, 6, 7, 8, 11, 12, 13) which are at an angle of 90° or 180° in relation to one another and
- severing or cutting the strip to the desired length, it being possible for the severing or cutting to be performed before or after the bending or buckling of the strip.

14. Method according to Claim 13, **characterized in that** the magnetic core is composed of at least two strips (1, 2).

## Revendications

1. Noyau magnétique pour des détecteurs de courant en un alliage magnétique doux, se composant d'au moins deux portions de bande d'alliage courbées ou pliées (5, 6, 7, 8, 11, 12, 13),
**caractérisé en ce que**
le noyau magnétique est composé d'une première partie de noyau magnétique (1) et d'une deuxième partie de noyau magnétique (2), les parties de noyau magnétique (1, 2) étant de forme symétrique l'une par rapport à l'autre, et la première partie et la deuxième partie de noyau magnétique (1, 2) sont disposées de telle façon que, du côté secondaire, les arêtes dirigées vers l'intérieur (18) de la ou des portion(s) de branche secondaire (5, 6) de la première partie de noyau magnétique (1) et les arêtes dirigées vers l'intérieur de la ou des portion(s) de branche secondaire (9, 10) de la deuxième partie de noyau magnétique (2) se touchent au moins partiellement, dont parmi les portions de branches qui se rencontrent, au moins une paire de branches (10, 12; 5, 9) forme un entrefer (17).

2. Noyau magnétique selon la revendication 1,
**caractérisé en ce que**
le noyau magnétique se compose de deux portions de bande d'alliage courbées.

3. Noyau magnétique selon la revendication 1 ou 2,
**caractérisé en ce que**
la bande d'alliage est courbée ou pliée de telle façon que les portions courbées ou pliées (5, 6, 7, 8, 11, 12, 13) de la bande d'alliage présentent un angle de 90° ou de 180° l'une par rapport à l'autre.

4. Noyau magnétique selon au moins une des revendications 1 à 3,
**caractérisé en ce que**
la branche secondaire est formée à partir d'au moins deux portions de bande d'alliage (5) et (6), de telle façon qu'à l'intérieur du noyau magnétique, il apparaisse dans la région de la branche secondaire une poche ou un espace creux (14), qui convient pour recevoir un détecteur de champ magnétique.

5. Noyau magnétique selon au moins une des revendications 1 à 4,
**caractérisé en ce que**
le noyau magnétique présente dans la région de la branche primaire une portion de bande d'alliage (7), qui est orientée parallèlement aux surfaces de la branche secondaire (5, 6).

6. Noyau magnétique selon au moins une des revendications 1 à 4,
**caractérisé en ce que**
le noyau magnétique présente une branche primaire, dont l'axe longitudinal (15) est orienté parallèlement à l'axe longitudinal (16) de la branche secondaire.

7. Noyau magnétique selon au moins une des revendications 1 à 5,
**caractérisé en ce que**
le noyau magnétique est composé d'une première partie de noyau magnétique (1) et d'une deuxième partie de noyau magnétique (2), les parties de noyau magnétique (1,2) étant de forme symétrique l'une par rapport à l'autre.

8. Noyau magnétique selon la revendication 7,
**caractérisé en ce que**
la première partie et la deuxième partie de noyau magnétique (1, 2) sont disposées de telle façon que, du côté secondaire, les arêtes dirigées vers l'intérieur (18) de la ou des portion(s) de branche secondaire (5, 6) de la première partie de noyau magnétique (1) et les arêtes dirigées vers l'intérieur de la ou des portion(s) de branche secondaire (9, 10) de la deuxième partie de noyau magnétique (2) se touchent au moins partiellement, dont parmi les portions de branches qui se rencontrent, au moins une paire de branches (10, 12; 5, 9) forme un entrefer (17).

9. Noyau magnétique selon au moins une des revendications 1 à 8,
**caractérisé en ce que**
la première partie de noyau magnétique (1) et la deuxième partie de noyau magnétique (2) sont disposées et formées de telle façon que, du côté primaire, la portion de branche de la première partie de noyau magnétique (7) et la portion de branche du côté primaire de la deuxième partie de noyau magnétique (11) se recouvrent à plat au moins partiellement.

10. Noyau magnétique selon au moins une des revendications 1 à 8,
**caractérisé en ce que**
la première et la deuxième partie de noyau magnétique (1, 2) sont de forme conique, de telle façon que, du côté primaire, la portion de branche conique de la première partie de noyau magnétique (7, 19) et la portion de branche conique de la deuxième partie de noyau magnétique (11) forment une surface rectangulaire commune (20) formée de deux triangles (19).

11. Noyau magnétique selon au moins une des revendications 1 à 8,
**caractérisé en ce que**
la première et la deuxième partie de noyau magnétique (1, 2) sont formées de façon telle que les surfaces latérales (13) soient obliques, de sorte que, du côté primaire, la portion de branche de la première partie (7) et la portion de branche de la deuxième partie (11) soient parallèles l'une à l'autre, les surfaces des portions de branche du côté primaire (7, 11) venant se placer sur un plan.

12. Détecteur de courant,
**caractérisé en ce qu'**
il contient un noyau magnétique selon la revendication 1.

13. Procédé pour fabriquer un noyau magnétique selon la revendication 1, comprenant les étapes suivantes :
- fabrication d'une bande d'alliage à partir d'une matière magnétique douce,
- courbure ou pliage de la bande d'alliage de telle façon qu'il apparaisse au moins deux portions de bande d'alliage (5, 6, 7, 8, 11, 12, 13), qui présentent un angle de 90° ou de 180° l'une par rapport à l'autre, et
- séparation ou coupure de la bande à la longueur souhaitée, la séparation ou la coupure de la bande pouvant être effectuée avant ou après la courbure ou le pliage de la bande.

14. Procédé selon la revendication 13,
**caractérisé en ce que**
le noyau magnétique est composé d'au moins deux bandes (1, 2).
